# FASCICULE DE BREVET EUROPEEN

(11) **EP 1 410 055 B1**
(45) Date de publication et mention de la délivrance du brevet: **28.02.2007**
(21) Numéro de dépôt: 01976420.8
(22) Date de dépôt: 12.10.2001
(51) Int. Cl.: G01R 33/465, C12Q 1/02, G01N 1/42, G01R 33/30, G01N 33/483

(54) **PROCEDE ET DISPOSITIF D'ANALYSE DE L'ETAT CHIMIQUE INTRACELLULAIRE DE CELLULES VIVANTES PAR RESONANCE MAGNETIQUE NUCLEAIRE**
VERFAHREN UND VORRICHTUNG ZUR ANALYSE DES INTRAZELLULÄREN CHEMISCHEN ZUSTANDES LEBENDER ZELLEN MITTELS KERNMAGNETISCHER RESONANZ
METHOD AND DEVICE FOR ANALYSING THE INTRACELLULAR CHEMICAL STATE OF LIVING CELLS BY NUCLEAR MAGNETIC RESONANCE

(30) Priorité: 13.10.2000 FR 0013183
(43) Date de publication de la demande: 21.04.2004
(73) Titulaire: Metabolic Explorer, 63360 Beauzire (FR); BRUKER SA, 67160 Wissembourg (FR)
(72) Inventeur: GONZALEZ, Benjamin, F-63000 Clermont-Ferrand (FR); PIOTTO, Martial, F-67540 Oswald (FR); HUBER, Gaspard, F-19100 Brive La Gaillarde (FR)
(74) Mandataire: Tetaz, Franck Claude Edouard
(86) Numéro de dépôt international: PCT/FR2001/003167
(87) Numéro de publication internationale: WO 2002/031523

(56) Documents cités:
- WO-A-92/01946
- FOWLER A H ET AL: "DIFFERENTIATION OF HUMAN PROSTATE CANCER FROM BENIGN HYPERTROPHY BY IN VITRO 1H NMR" MAGNETIC RESONANCE IN MEDICINE,US,ACADEMIC PRESS, DULUTH, MN, vol. 25, no. 1, 1 mai 1992 (1992-05-01), pages 140-147, XP000275042 ISSN: 0740-3194
- QUISTORFF BJORN ET AL: "Methods for liquid- and solid-state CP-MAS NMR spectroscopy of untreated tissue biopsies." ANALYTICAL BIOCHEMISTRY, vol. 213, no. 1, 1993, pages 68-74, XP001007253 ISSN: 0003-2697
- DE KONING W ET AL: "A METHOD FOR THE DETERMINATION OF CHANGES OF GLYCOLYTIC METABOLITES IN YEAST ON A SUBSECOND TIME SCALE USING EXTRACTION AT NEUTRAL PH" ANALYTICAL BIOCHEMISTRY, vol. 204, no. 1, 1992, pages 118-123, XP001007232 ISSN: 0003-2697 cité dans la demande
- WIND R A ET AL: "An investigation of rat mammary healthy and R3230AC tumor tissues and cells by means of solid-state /sup 13/C NMR" SOLID STATE NUCLEAR MAGNETIC RESONANCE, DEC. 1996, ELSEVIER, NETHERLANDS, vol. 7, no. 3, pages 263-269, XP001007010 ISSN: 0926-2040
- CHENG L L ET AL: "Enhanced resolution of proton NMR spectra of malignant lymph nodes using magic-angle spinning" MAGNETIC RESONANCE IN MEDICINE, NOV. 1996, WILLIAMS & WILKINS, USA, vol. 36, no. 5, pages 653-658, XP002170690 ISSN: 0740-3194
- TATE A R ET AL: "Distinction between normal and renal cell carcinoma kidney cortical biopsy samples using pattern recognition of /sup 1/H magic angle spinning (MAS) NMR spectra" NMR IN BIOMEDICINE, APRIL 2000, WILEY, UK, vol. 13, no. 2, pages 64-71, XP002170691 ISSN: 0952-3480
- MIDDLETON D A ET AL: "The effect of sample freezing on proton magic-angle spinning NMR spectra of biological tissue" MAGNETIC RESONANCE IN MEDICINE, JULY 1998, WILLIAMS & WILKINS, USA, vol. 40, no. 1, pages 166-169, XP002170692 ISSN: 0740-3194 cité dans la demande
- WATERS N J ET AL: "High-resolution magic angle spinning 1H NMR spectroscopy of intact liver and kidney: Optimization of sample preparation procedures and biochemical stability of tissue during spectral acquisition." ANALYTICAL BIOCHEMISTRY, vol. 282, no. 1, 15 juin 2000 (2000-06-15), pages 16-23, XP002170693 ISSN: 0003-2697
- HIDETO HANAOKA: "IN VITRO CHARACTERIZATION OF LUNG CANCERS BY THE USE OF 1H NUCLEAR MAGNETIC RESONANCE SPECTROSCOPY OF TISSUE EXTRACTS AND DISCRIMINANT FACTOR ANALYSIS" MAGNETIC RESONANCE IN MEDICINE,US,ACADEMIC PRESS, DULUTH, MN, vol. 29, no. 4, 1 avril 1993 (1993-04-01), pages 436-440, XP000368010 ISSN: 0740-3194
- ALLEN P J ET AL: "APPARATUS FOR LOW-TEMPERATURE MAGIC-ANGLE SPINNING NMR" JOURNAL OF MAGNETIC RESONANCE,US,ACADEMIC PRESS, ORLANDO, FL, vol. 92, no. 3, 1 mai 1991 (1991-05-01), pages 614-617, XP000203289 ISSN: 1090-7807

## Description

La présente invention concerne un procédé non invasif d'analyse *in vivo* du métabolisme intracellulaire. Le procédé utilise la résonance magnétique nucléaire (RMN) pour mesurer l'état chimique intracellulaire des cellules animales, végétales ou de micro-organismes cultivés dans des conditions définies et contrôlées.

L'invention concerne en particulier un procédé d'analyse de l'état chimique intracellulaire de cellules vivantes par RMN qui comprend une étape de préparation de l'échantillon de cellules et une étape d'analyse de l'échantillon par RMN réalisées à très basse température afin de figer l'état biochimique des cellules vivantes de façon à avoir des mesures reproductibles, spécifiques et justes du fonctionnement cellulaire dans des conditions données.

Les concentrations intracellulaires sont des paramètres fondamentaux pour caractériser et corréler l'influence des modifications génétiques et environnementales sur le fonctionnement de la cellule (Weuster-Botz *et al.,* 1996 ; Teusink *et al.,* 1998). Par la mesure des concentrations intracellulaires, il est possible de déterminer un profil métabolique spécifique de l'organisme vivant cultivé dans des conditions standards et de comparer ce profil à ceux obtenus après modifications génétiques ou après diverses conditions de culture.

Les techniques dédiées à la détermination *in vivo* des paramètres intracellulaires se divisent en 2 groupes : les méthodes invasives et les méthodes non invasives.

Les méthodes invasives nécessitent une destruction des cellules et une extraction des composés chimiques intracellulaires. Ces deux étapes se déroulent dans des conditions physico-chimiques extrêmes. En conséquence, il est fréquent de trouver dans la littérature des données contradictoires pour les concentrations intracellulaires d'un même organisme cultivé dans les mêmes conditions (Gancedo *et al.*, 1973; Weuster-Botz *et al.,* 1996 ; Gonzalez *et al.,* 1997).

Les méthodes non invasives comme la résonance magnétique nucléaire (RMN) présentent l'avantage de caractériser l'état chimique intracellulaire de cellules vivantes sans perturbation du métabolisme cellulaire (Gadian et *al.,* 1983). De nombreuses revues scientifiques montrent que cette technique est l'outil analytique le mieux adapté pour l'analyse *in vivo* du métabolisme intracellulaire (Jeffrey *et al.,* 1991 ; Cameron *et al.,* 1997).

Dans ce contexte, il a déjà été proposé de réaliser la détection de l'état chimique de systèmes vivants par RMN. On peut citer, à cet égard la demande internationale de brevet WO 92/01946, qui vise un procédé de mesure par résonance magnétique nucléaire de l'état chimique de systèmes vivants animaux ou humains, selon le préambule de la revendication 1.

Si avec ce dispositif il est possible de détecter des dysfonctionnements cellulaires sur des tissus par rapport à une référence définie sur des tissus sains, il est beaucoup plus difficile de l'appliquer pour corréler et caractériser spécifiquement une fonction cellulaire de micro-organismes, de cellules animales et de cellules végétales par la mesure RMN de l'état chimique intracellulaire. En effet, la sensibilité des systèmes vivants aux conditions environnementales rend difficile l'application de ce dispositif pour mesurer l'état chimique intracellulaire des cellules et surtout pour corréler spécifiquement cet état aux conditions expérimentales. Ceci a été confirmé par Middleton *et al.* (1998) qui ont montré l'influence des conditions de préparation de tissus biologiques malades sur les profils métaboliques obtenus par RMN haute résolution à l'angle magique (plus connu sous l'acronyme RMN HR MAS signifiant High Resolution Magic Angle Spinning en anglais). Par ces expériences, ils ont souligné la difficulté de corréler les facteurs pathologiques expérimentés et les profils métaboliques mesurés avec le dispositif mentionné plus haut.

L'origine des difficultés pour associer spécifiquement un profil intracellulaire mesuré par les dispositifs RMN aux conditions expérimentales réside dans la méthode et le temps écoulé pour la préparation et la mesure des échantillons. Il est important de souligner que les vitesses des réactions métaboliques et particulièrement de celles impliquées dans le métabolisme énergétique sont élevées ; par exemple la vitesse de conversion du glucose intracellulaire est de 1 mmol.l⁻¹s⁻¹ et celle de l'ATP (Adénosine-Tri-Phosphate) est de 1,5 mmol.l^{-l}s⁻¹ (De Koning et van Dam, 1992 ; Theobald et *al.,* 1993). Les teneurs intracellulaires reportées dans la littérature pour ces deux composés sont inférieures à 4 mmol.l⁻¹ (Ryll *et al.*, 1991 ; Seiler *et al.,* 1994). Ces données montrent qu'un temps de prélèvement et/ou un temps de mesure supérieur à 6 secondes a pour conséquence des variations importantes des concentrations intracellulaires.

Il est donc indispensable pour obtenir des mesures par RMN reproductibles et spécifiques du fonctionnement cellulaire pour une condition donnée de maintenir les cellules dans un état stable non seulement entre le temps to, de prélèvement des cellules depuis le procédé de culture des cellules et le temps t₁ de mesure de l'état chimique par résonance magnétique nucléaire, mais aussi pendant la mesure RMN.

La présente invention se propose donc de résoudre ces problèmes en fournissant un procédé permettant de figer l'état chimique des cellules mesuré par RMN afin de dresser avec précision le profil (code barre, signature) des métabolites intracellulaires spécifiques du type cellulaire et des conditions expérimentales.

La présente invention concerne un procédé d'analyse de l'état chimique de cellules vivantes en utilisant la résonance magnétique nucléaire (RMN) par comparaison d'au moins un spectre de RMN et/ou d'au moins une valeur de mesure de RMN obtenue sur un échantillon desdites cellules vivantes avec au moins un spectre de RMN et/ou d'au moins une valeur de mesure de RMN de référence obtenue sur au moins un échantillon de cellules vivantes de référence, de façon à identifier au moins un pic dudit spectre de RMN et/ou au moins une valeur de mesure de RMN constituant un marqueur spécifique de l'état métabolique desdites cellules vivantes caractérisé en ce qu'il comprend une étape de préparation dudit échantillon dans des conditions permettant de figer l'état chimique desdites cellules vivantes.

C'est aussi un but de l'invention de fournir un procédé de préparation de l'échantillon qui assure la stabilité de l'état chimique intracellulaire depuis le prélèvement jusqu'à la mesure par RMN. Ainsi, le procédé selon l'invention se caractérise en ce que pour préparer ledit échantillon on le soumet à une très basse température pendant un temps suffisant pour arrêter les réactions intracellulaires entre le moment du prélèvement dudit échantillon et le moment de mesure de l'état chimique des cellules, et éventuellement également pendant toute la durée de l'analyse.

L'invention concerne également un procédé caractérisé en ce que la préparation dudit échantillon comprend les étapes suivantes:
a) l'immersion directe et immédiate dudit échantillon dans l'azote liquide;
b) la lyophilisation dudit échantillon ;
c) éventuellement le stockage dudit échantillon à très basse température ;
d) au moment souhaité pour l'analyse, le mélange et la remise en solution à très basse température dudit échantillon lyophilisé avec un solvant ayant un point de fusion très bas.

Selon un mode particulier de réalisation de l'invention, le procédé selon l'invention est caractérisé en ce que à la place de l'azote liquide, on utilise un mélange eau/méthanol tamponné à très basse température. Selon un mode préféré de réalisation de l'invention, le mélange eau/méthanol est tamponné à pH 7,5 et contient 50% de méthanol. Il est également dans l'étendue de l'invention d'utiliser d'autres composés organiques en mélange avec l'eau qui varient de par la nature du composé organique employé, de par la proportion du composé organique dans le mélange, de par le pH du mélange. La présente invention concerne tous les mélanges composés organiques/eau et plus particulièrement alcool/eau pour lesquels le point de fusion (Pf) est inférieur à 0° C. Parmi les composés organiques autres qu'un alcool en mélange avec l'eau, on peut citer l'acétone (Pf = - 95° C) ou le chloroforme (Pf =-64°C).

Selon un mode de réalisation de l'invention, le procédé se caractérise en ce que ledit solvant est un mélange eau deutérée/méthanol deutéré et contient 50% de méthanol. De même, il est également dans l'étendue de l'invention d'utiliser d'autres types de solvant composé de mélanges eau deutérée/composé organique deutéré et plus particulièrement eau deutérée/alcool deutéré. Les autres types de solvant concernent tous les mélanges eau deutérée/composé organique deutéré. Ces mélanges peuvent varier par la nature du composé organique deutéré employé, par la proportion de composé organique deutéré dans le mélange, ou par le pH du mélange par exemple. Les points de fusion des solvants deutérés diffèrent peu des solvants équivalents protonés. Le solvant le plus sensible à la deutériation est probablement H₂O, puisque le point de fusion du D₂O est de 3,8°C.

Selon un mode de réalisation de l'invention, le procédé se caractérise en ce que ladite très basse température à laquelle est soumis l'échantillon pendant sa préparation, son stockage et pendant la durée de l'analyse de RMN est inférieure à 0°C. De manière préférée, ladite très basse température pour la préparation et le stockage de l'échantillon est comprise entre -10 et -80°C, et de manière encore préférée, ladite très basse température est inférieure ou égale à -80°C. De manière très préférée, l'échantillon est stocké dans l'azote liquide pour une plus grande stabilité. De manière préférée, ladite très basse température pendant la durée de l'analyse de l'échantillon est comprise entre -20°C et +5°C de telle sorte que ladite température soit compatible avec l'utilisation du rotor et de la sonde.

Le procédé d'analyse de l'état chimique de ladite cellule selon l'invention utilise la RMN munie d'une sonde liquide, la RMN munie d'une sonde HRMAS haute résolution, de préférence par RMN HRMAS à deux dimensions.

Selon un mode préféré de réalisation de l'invention, le procédé selon l'invention est caractérisé en ce que lesdites cellules vivantes sont cultivées ou incubées dans un milieu de culture cellulaire ou tissulaire qui contient des molécules enrichies en isotopes stables. De manière plus préférée, lesdites molécules comprennent une source de carbone 13 et/ou une source d'azote 15.

Les cellules vivantes selon l'invention sont des cellules procaryotes ou eucaryotes, animales ou végétales. Sans en dresser une liste exhaustive, des exemples de cellules vivantes selon l'invention sont donnés ci-après. Parmi les cellules procaryotes, il convient de citer les algues bleu-vert, les myxobactéries, les spirochètes, les eubactéries, les rickettsies les chlamydies, les mycoplasmes, les archéobactéries. Parmi les eubactéries, il convient de citer les entérobactéries telles *Escherichia coli,* les Bacillus tels *Bacillus subtilis,* les Pseudomonas, les Campylobacter, les Rhizobium, les Agrobacterium, les Azotobacter, les Micrococcus, les Staphylococcus, les Streptococcus, les Lactobacillus. Parmi les cellules de micro-organismes eucaryotes, il convient de citer les algues vertes, brunes ou rouges, les champignons tels les phycomycètes, les ascomycètes, les basidiomycètes, les levures. Parmi les levures, il convient de citer *Saccharomyces cerevisiae, Saccharomyces pombe, candida albicans.* Parmi les cellules animales, il convient de citer de préférence les cellules humaines et les cellules de mammifères tels les bovins, les ovins, les caprins, le porc, les équidés, les rongeurs tels la souris et le rat par exemple.

Le procédé selon l'invention est caractérisé en ce qu'il est utilisé pour identifier des cellules vivantes dont l'état physiologique dévie de la norme. Un tel procédé permet d'identifier des cellules vivantes appartenant au groupe composé par exemple de cellules présentant un défaut génétique constitutionnel ou acquis et des cellules soumises à un stress environnemental. Par stress environnemental, on entend désigner un agent physique, chimique ou biologique provoquant une réaction de la cellule. Parmi les agents physiques, il convient de citer entre autres les rayons béta, les rayons gamma, les rayons X, les ultraviolets, les infra-rouges, la lumière visible. Egalement, des conditions de culture, aérobie ou anaérobie, le pH du milieu de culture, acide, basique ou neutre, la concentration en gaz carbonique ou d'un autre élément dans le milieu de culture, la température constituent des agents physiques selon l'invention. Par agent chimique, on entend désigner tout composé chimique susceptible d'interagir avec la cellule ou un des composants cellulaires membranaires ou intracellulaires ; par exemple, les agents intercalants tels le bromure d'éthidium, l'iodure de propidium constituent des composés chimiques selon l'invention. Les composés biologiques de l'invention correspondent à tous les composés susceptibles de provoquer une réaction biologique cellulaire. On peut citer de manière non exhaustive toutes les molécules interagissant avec un récepteur membranaire tels par exemple les molécules de la communication intercellulaire, les hormones, les cytokines, les lymphokines, les interleukines, les anticorps. Les virus constituent également des agents biologiques selon l'invention. Les agents biologiques selon l'invention incluent également les facteurs génétiques. Ces facteurs génétiques affectent le métabolisme cellulaire ; ces facteurs peuvent être constitutionnels, comme par exemple dans le cas de maladies génétiques telles par exemple la myopathie de Duchenne, la dystrophie myotonique de Steinert, la mucoviscidose, l'amyotrophie spinale, la sclérose latérale amyotrophique. Ces facteurs peuvent être acquis comme dans le cas de mutations ou de remaniements chromosomiques, tels une délétion, une insertion, une translocation, une intégration virale. Selon l'invention, lesdites cellules présentant un défaut génétique constitutionnel ou acquis appartiennent de préférence au groupe des cellules cancéreuses, ou des cellules humaines de patient atteint d'un défaut génétique constitutionnel, ou des cellules infectées par un virus.

Le procédé selon l'invention se caractérise en ce que ledit marqueur spécifique est utilisé pour le criblage de molécules chimiques ou biologiques.

Selon un autre mode de réalisation de l'invention, le procédé selon l'invention se caractérise en ce qu'il est utilisé pour identifier un métabolite intracellulaire spécifique d'un type cellulaire et/ou d'un état métabolique cellulaire et/ou de conditions environnementales cellulaires.

Le procédé selon l'invention peut également être utilisé pour déterminer la répartition de métabolites intracellulaires ayant incorporés ledit isotope stable, par exemple carbone 13 ou azote 15. Le procédé selon l'invention peut également être utilisé pour déterminer qualitativement les voies métaboliques à l'origine de la formation desdits métabolites et/ ou pour déterminer quantitativement les flux intracellulaires générés par la catalyse enzymatique.

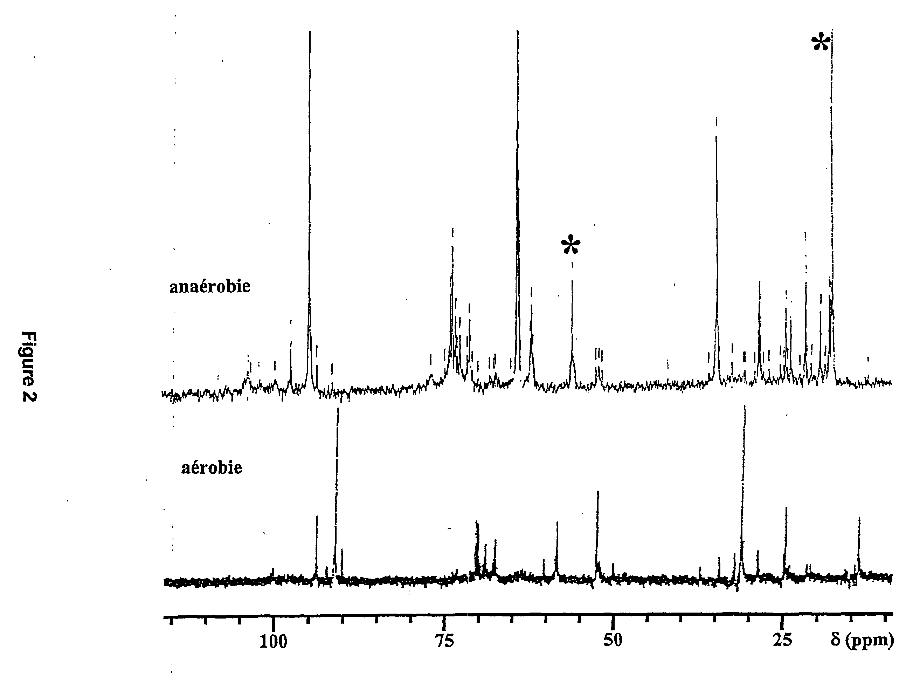

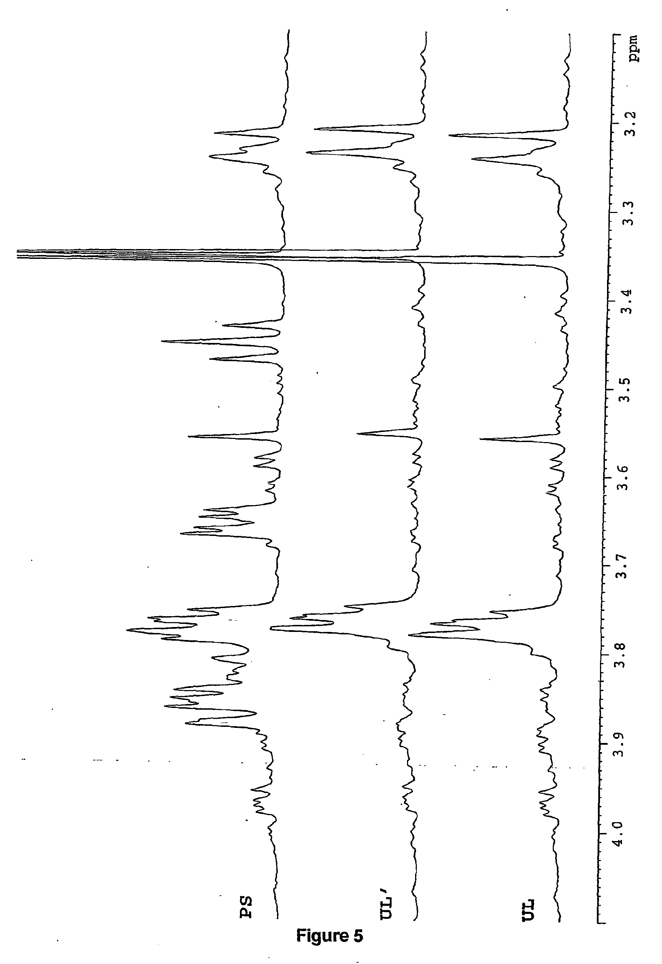

La présente invention comprend également la fourniture d'un marqueur spécifique susceptible d'être obtenu par le procédé selon l'invention. Un exemple de marqueur spécifique est présenté sur la figure 2. L'expérience a consisté à observer le spectre RMN¹³C, avec découplage des protons, 10 minutes avant et 25 minutes après le passage d'une culture de cellules de levure dans des conditions d'aérobie stricte à une culture dans des conditions anaérobies. Des variations très importantes d'intensité, voire des apparitions de pics sont observées, et constituent des marqueurs spécifiques. Ainsi les signaux C1 (55.9 ppm) et C2 (18.0 ppm) de l'éthanol apparaissent en conditions anaérobies, alors que ces signaux ne sont pas significatifs sur le spectre de levures en conditions aérobies. Au contraire, le signal à 91.3 ppm correspondant au C1 du tréhalose disparaît presque entièrement. Un autre exemple de marqueurs spécifiques est observable sur la figure 5.

Enfin, l'invention comprend aussi l'utilisation du pic de spectre de RMN ou de la valeur de mesure de RMN telle qu'identifié par la mise en oeuvre du procédé selon l'invention comme marqueur d'un état métabolique donné pour le criblage de cellules vivantes. L'invention concerne donc également un procédé de criblage de cellules vivantes pour l'identification de cellules présentant un état métabolique donné caractérisé en ce qu'on utilise le marqueur selon l'invention. L'invention porte également sur l'utilisation du marqueur selon l'invention pour le criblage de molécules chimiques ou biologiques.

L'invention se sert d'un dispositif qui comprend un aimant supraconducteur, une console électronique, une sonde de mesure RMN et une unité de réfrigération.

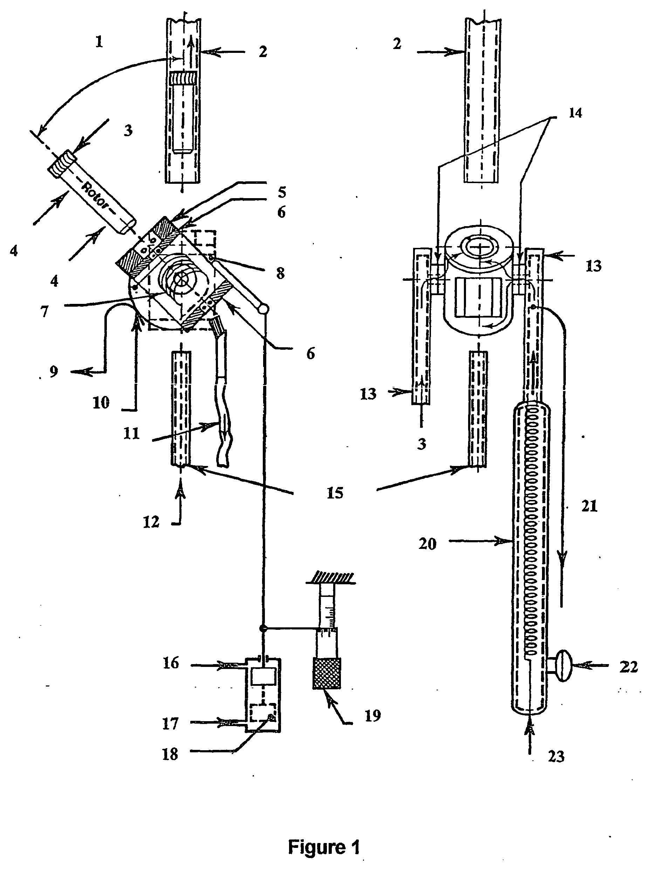

Le rôle de l'aimant supraconducteur est de générer un champ magnétique intense (jusqu'à 18,8 T), homogène sur un volume suffisamment important et dont l'intensité est stable dans le temps. La console électronique permet de générer des impulsions haute fréquence (jusqu'à 800 MHz) et de fortes puissances (50W) et de recueillir les signaux émis par l'échantillon. La tête de mesure (brevet européen EP0856741), commercialisée par BRUKER (code article B 1867), accueille l'échantillon et lui transmet les impulsions haute fréquence. Elle assure également la détection du signal émis. Le composé soumis à la mesure est contenu dans un rotor en oxyde de zirconium de 4 mm de diamètre. Il est introduit dans la sonde par le haut de l'aimant à l'aide d'une canne de transfert (code article BRUKER K0219) et vient se placer au centre d'une bobine radiofréquence en forme de solénoïde. La partie contenant la bobine et l'échantillon est appelée stator et possède la caractéristique remarquable d'être mobile et, grâce à une commande pneumatique, de pouvoir basculer de sorte que l'axe de la bobine, et par voie de conséquence, de l'échantillon, fasse un angle de 54,7° par rapport au champ magnétique principal généré par l'aimant (figure 1). Une fois dans cette position, la turbine est soulevée et mise en lévitation par un flux pneumatique axial (bearing) d'environ 1500 mbars arrivant par le bas du rotor. Celui-ci est hermétiquement fermé grâce à un capuchon en KelF qui possède des ailettes permettant la mise en rotation. Celle-ci est réalisée à l'aide d'un second flux pneumatique (drive), de direction tangentielle par rapport à la turbine. La pression du drive est d'environ 500 mbars et le flux d'air qui arrive sur les ailettes du capuchon permet d'atteindre des vitesses de rotation de l'ordre de 15000 tr/sec. Les pressions de bearing et drive, le basculement du stator ainsi que l'éjection de l'échantillon sont contrôlés par une unité pneumatique BRUKER (code article H2620).

L'angle de 54°7 que fait l'échantillon avec le champ magnétique principal est appelé couramment angle magique. Il permet en effet de moyenner les importantes différences de susceptibilité magnétique présentes dans des échantillons de cellules vivantes. Cette propriété permet d'obtenir des signaux RMN nettement plus fins que ceux obtenus en utilisant des techniques de RMN classique haute résolution liquide qui n'utilisent pas le concept de la rotation à l'angle magique. La technique utilisée est alors connue sous le nom de RMN haute résolution à l'angle magique (RMN HRMAS).

L'unité de réfrigération, commercialisée par BRUKER sous le nom BCU05 (code article W1210342), est essentielle, puisqu'elle permet de ralentir considérablement, voire de geler, les processus métaboliques de façon à pouvoir étudier par RMN les différents composants chimiques se trouvant à l'intérieur de la cellule sans que leurs propriétés ne soient altérées au cours de la mesure RMN. Cette unité refroidit le flux d'air sec servant à la mise en lévitation de l'échantillon (bearing) à des températures pouvant atteindre - 20°C, assurant ainsi des températures similaires au niveau de l'échantillon. Cette unité fonctionne au moyen d'air sec et permet de générer un débit d'air pouvant atteindre 2500 l/h. Ce flux de gaz doit permettre à l'échantillon d'atteindre les vitesses de rotation élevées requises pour ce type d'expériences. Le débit et la température de l'air doivent être suffisamment stables pour garantir une bonne stabilité de la vitesse de rotation et de la température afin d'empêcher l'apparition d'artéfacts parasites dans les spectres RMN. Le raccord de l'unité de réfrigération doit pouvoir supporter des pressions importantes tout en étant suffisamment flexible pour pouvoir se connecter facilement à la sonde et absorber d'éventuelles vibrations qui pourraient nuire à la mesure RMN.

Ce dispositif se caractérise en ce qu'il permet de réaliser la mesure RMN à une température régulée inférieure à 0°C, de préférence entre 0 et -20°C.

D'autres caractéristiques et avantages de la présente invention seront mieux mis en évidence à la lecture des exemples suivants. Dans ces exemples, on se référera aux figures suivantes :

### FIGURES

**Figure 1 : Schéma général du dispositif.**
   1. Angle magique : 54,735°
   2. Canne d'injection et d'éjection
   3. Gaz de rotation (drive)
   4. Gaz porteur (bearing)
   5. Blindage
   6. Céramiques de support
   7. Bobine RF
   8. Stator en position verticale pour éjecter l'échantillon
   9. Vers les circuits d'accord
   10. Contact mobile
   11. Câble de mesure de la vitesse de rotation
   12. Air pour éjection de l'échantillon
   13. Tube support
   14. Pivots hermétiques
   15. Tubes servant à l'éjection de l'échantillon
   16. Arrivée d'air pour la mise en position verticale
   17. Arrivée d'air pour la mise en position à l'angle magique
   18. Piston pneumatique
   19. Vis micrométrique pour réglage de l'angle magique
   20. Dewar
   21. Thermocouple
   22. Arrivée de gaz porteur
   23. Résistance chauffante
**Figure 2 : Spectre RMN ¹³C avec découplage des protons :**
   - **en conditions d'aérobie stricte (en bas).**
      Conditions expérimentales : temps d'acquisition 1s, temps d'attente 5s, 350 acquisitions, durée d'enregistrement 30mn, vitesse de rotation de l'échantillon 1 kHz.
   - **25 minutes après le passage de conditions d'aérobie stricte à des conditions d'anaérobie (en haut).**
      Conditions expérimentales : temps d'acquisition 1 s, temps d'attente 5s, 639 acquisitions, durée d'enregistrement 53mn, vitesse de rotation de l'échantillon 1 kHz. Les signaux caractéristiques de l'éthanol sont indiqués par un astérisque.

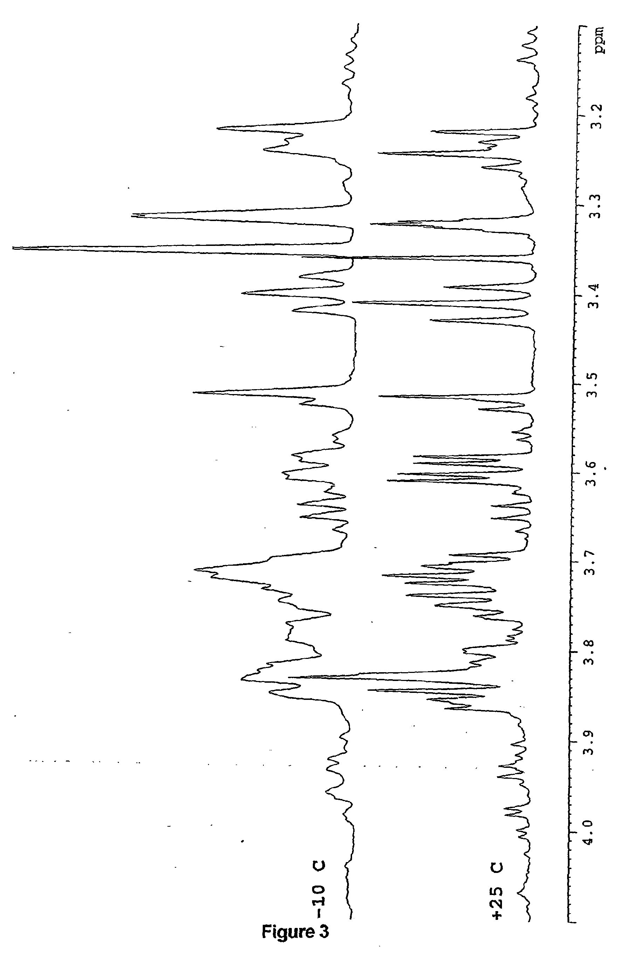

**Figure 3 : Influence de la température sur la résolution des spectres protons effectués par RMN HR MAS sur des levures.** Le spectre proton obtenu à -10°C (spectre du haut) montre une résolution légèrement inférieure à celle observée sur le spectre obtenu à une température ambiante (+25°C) (spectre du bas).
   Conditions expérimentales : 7 mg de cellules lyophilisées, solvant 50 µl méthanol-d4:D₂O dans le rapport volumique 1:1, temps d'acquisition 1,4s, temps de pré-saturation 0,9 s, 256 acquisitions, durée d'enregistrement 10mn, vitesse de rotation de l'échantillon 4 kHz. Le D₂O contient 0,75% de TSP (acide tri-silyle-d4-propionate comme référence en déplacement chimique).

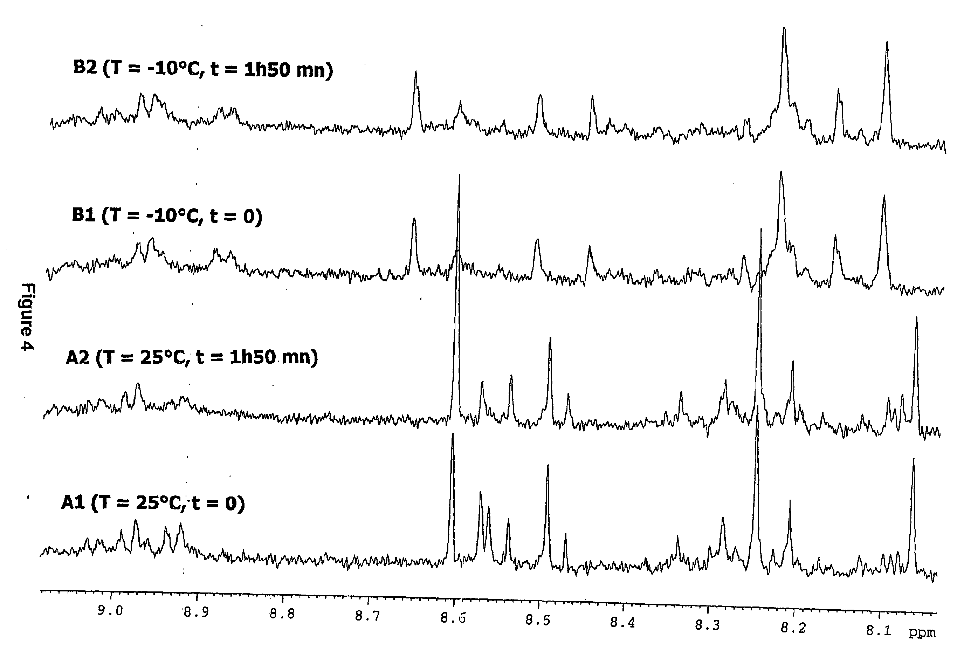

**Figure 4: Influence de la température sur la stabilité des spectres protons effectués par RMN HR MAS sur des levures.** Les conditions de préparation des échantillons et d'enregistrement des spectres sont identiques à celles de la figure 3. L'expérience a été réalisée à +25°C (spectres A1 et A2) et à -10°C (spectres B1 et B2). Les spectres ont été enregistrés immédiatement après préparation de l'échantillon et réglages du spectromètre (spectres A1 et B1), puis après 1h50mn dans les conditions d'acquisition de données RMN en maintenant constante la température (A2 et B2). On observe une beaucoup plus grande stabilité de l'échantillon nettement supérieure à -10°C qu'à +25°C. Par exemple, à +25°C, dans la zone du spectre décrite par la figure, les signaux à 8.93, 8.92 et 8.56 ppm disparaissent presque entièrement tandis que les signaux à 8.61, 8.10 et 8.08 ppm augmentent nettement d'intensité. Au contraire, à -10°C, les variations d'intensité restent très faibles sur tout le spectre.
**Figure 5 : Caractérisation de levures par RMN ¹H.** Les conditions de préparation des échantillons sont identiques à celles de la figure 3. Spectres proton de deux cultures d'ultralevure (UL et UL') et d'une culture de levure de panification (PS) stoppées au moment de la consommation totale du glucose (10 g de glucose par litre de culture). Cet instant est défini par un dosage enzymatique du glucose. Les spectres de UL et UL' montrent une très bonne reproductibilité de toutes les étapes expérimentales menant à l'enregistrement des spectres. Les différences spectrales entre UL et PS permettent aisément de distinguer les deux levures. Conditions expérimentales RMN identiques à celles de la figure 3, sauf T=+2°C et solvant 50 µl D₂O.

### EXEMPLES

### 1. MATERIEL ET METHODES

Les cellules sont prélevées directement à partir de la culture cellulaire et plongées directement dans l'azote liquide ou dans un mélange eau/méthanol (50 % en volume) à -40°C. Cette étape a pour objectif de stopper par le froid les réactions intracellulaires. Le gradient de température imposé aux cellules optimise la vitesse du transfert de chaleur et a pour conséquence un arrêt instantané du métabolisme intracellulaire.

Les cellules sont ensuite centrifugées. Le culot cellulaire est rincé deux fois au PBS (Phosphate Buffer Saline, tampon salin phosphate), puis centrifugé une dernière fois. Les cellules sont ensuite lyophilisées et stockées à - 80°C.

L'échantillon à mesurer est préparé en mélangeant, directement à 0°C, dans le rotor porte-échantillon, 7 mg de cellules lyophilisées à une solution de 50 µl de mélange méthanol deutéré et eau deutérée dans un rapport volumique de 1 : 1 et contenant 0,375% de TSP comme référence de déplacement chimique. Après 10 secondes d'agitation au vortex pour homogénéiser l'échantillon, le rotor est transporté dans un bain de glace pilée et est prêt pour analyse par RMN. Le spectre est enregistré après mise en rotation du rotor, stabilisation de la température de l'échantillon, synthonisation de la tête de mesure et optimisation de l'homogénéité du champ magnétique Bo. L'ensemble de ces opérations de réglage ne doit pas dépasser 5 mn.

### 2. RESULTATS

La figure 3 montre que la résolution des spectres est légèrement inférieure à basse température. Celle-ci reste toutefois très acceptable pour l'analyse et l'interprétation de spectres RMN HRMAS obtenus ainsi.

La figure 4 montre une stabilité bien supérieure de l'échantillon à basse température. Ce résultat montre que les spectres enregistrés à -10°C donnent une image beaucoup plus exacte de l'état cellulaire à examiner que les spectres obtenus à température ambiante. La méthode, qui bloque l'état cellulaire grâce à l'abaissement de la température, permet donc d'améliorer notablement la sensibilité de la mesure en rendant possible l'augmentation de la durée d'acquisition des spectres RMN. Le fait de geler l'état des systèmes biologiques à étudier donne alors la possibilité d'enregistrer des expériences de RMN à deux dimensions (RMN 2D). Celles-ci, de types homo-nucléaires (ex : COSY, TOCSY, NOESY) ou hétéro-nucléaires (ex : corrélation inverse ¹H-¹³C ou ¹H-¹⁵N de type HSQC, HMQC et/ou HMBC) permettent d'apporter des informations structurales et dynamiques sur les métabolites étudiés. D'autre part, la RMN 2D permet d'augmenter très nettement la résolution grâce, notamment, à la dispersion spectrale sur la deuxième dimension.

Les figures 2 et 5 montrent la possibilité de caractériser en quelques minutes une culture cellulaire. Par comparaison à une banque de données, des échantillons cellulaires peuvent être caractérisés par leur type (figure 5) ou leurs conditions de culture (figure 2). Ces exemples peuvent facilement être étendus à d'autres variations de culture de cellules (milieu de culture, pH, température, instant du prélèvement) et à des différences génétiques se répercutant sur le réseau métabolique (mutations).

### REFERENCES

Cameron *et al.* (1997) Curr. Opin. Biotechnol. 8 : 175-80.
De Koning *et al.* (1992) Anal Biochem. 204 : 118-123.
Gadian *et al.* (1983) Oxford University Press (Eds), Oxford, UK.
Gancedo *et al.* (1973) Biochimie 55 : 205-211.
Gonzalez *et al.* (1997) Yeast 13 : 1347 - 1356.
Jeffrey *et al.* (1991) Trends Biochem. Sci. 16 : 5-10.
Middleton *et al.* (1998) Magn Reson Med. 40 : 166-169.
Ryll *et al.* (1991) J Chromatogr. 570 : 77-88.
Seiler *et al.* (1994) Institute of Biotechnology, ETH, Zurich.
Teusink *et al.* (1998) J. Bacteriol. 180 : 556-562.
Theobald *et al.* (1996) Biotechnology Techniques. 10 : 297-302.
Weuster-Botz *et al.* (1996) Adv. Biochem. Eng. Biotech. 34 : 75-108.

## Revendications

1. Procédé d'analyse de l'état chimique de cellules vivantes en utilisant la résonance magnétique nucléaire (RMN) par comparaison d'au moins un spectre de RMN et/ou d'au moins une valeur de mesure de RMN obtenue sur un échantillon desdites cellules vivantes avec au moins un spectre de RMN et/ou d'au moins une valeur de mesure de RMN de référence obtenue sur au moins un échantillon de cellules vivantes de référence, de façon à identifier au moins un pic dudit spectre de RMN et/ou au moins une valeur de mesure de RMN constituant un marqueur spécifique de l'état métabolique desdites cellules vivantes, **caractérisé en ce qu'**il comprend une étape de préparation dudit échantillon dans des conditions permettant de figer l'état chimique desdites cellules vivantes, ledit échantillon étant soumis à une très basse température pendant un temps suffisant pour arrêter les réactions intracellulaires entre le moment du prélèvement dudit échantillon et le moment de mesure de l'état chimique des cellules, et également pendant toute la durée de l'analyse, ladite préparation dudit échantillon comprenant les étapes suivantes :
a) L'immersion directe et immédiate dudit échantillon dans l'azote liquide ou un mélange eau/méthanol tamponné à très basse température;
b) La lyophilisation dudit échantillon ;
c) Eventuellement le stockage dudit échantillon à très basse température ;
d) Au moment souhaité pour l'analyse, le mélange et la remise en solution à très basse température dudit échantillon lyophilisé avec un solvant ayant un point de fusion très bas.

2. Procédé selon la revendication 1, **caractérisé en ce que** ledit mélange eau/méthanol est tamponné à pH 7,5 et contient 50% de méthanol.

3. Procédé selon les revendications 1 à 2, **caractérisé en ce que** ledit solvant est un mélange eau deutérée/méthanol deutéré tamponné à pH 7,5 et contient 50% de méthanol.

4. Procédé selon les revendications 1 à 3, **caractérisé en ce que** ladite très basse température est inférieure à 0°C.

5. Procédé selon la revendication 4, **caractérisé en ce que** ladite très basse température est comprise entre -10 et -80°C.

6. Procédé selon la revendication 4, **caractérisé en ce que** ladite très basse température est inférieure ou égale à -80°C.

7. Procédé selon l'une quelconque des revendications précédentes, **caractérisé en ce que** la température pendant la durée de l'analyse de RMN est inférieure à 0°C.

8. Procédé selon la revendication 7, **caractérisé en ce que** ladite température est comprise entre -5°C et -20°C.

9. Procédé selon l'une quelconque des revendications précédentes, **caractérisé en ce que** l'analyse de l'état chimique de ladite cellule est effectuée par RMN HRMAS, de préférence par RMN HRMAS à deux dimensions.

10. Procédé selon l'une quelconque des revendications précédentes, **caractérisé en ce que** ledit échantillon est prélevé dans un milieu de culture cellulaire ou tissulaire qui contient des molécules enrichies en isotopes stables dans lequel lesdites cellules vivantes sont cultivées ou incubées.

11. Procédé selon la revendication 10, **caractérisé en ce que** lesdites molécules comprennent une source de carbone 13 et/ou une source d'azote 15.

12. Procédé selon l'une quelconque des revendications précédentes, **caractérisé en ce que** lesdites cellules vivantes sont des cellules procaryotes ou eucaryotes, animales ou végétales.

13. Utilisation d'un procédé selon l'une quelconque des revendications précédentes pour identifier des cellules vivantes dont l'état physiologique dévie de la norme.

14. Utilisation selon la revendication 13, **caractérisée en ce que** lesdites cellules vivantes appartiennent au groupe composé de cellules présentant un défaut génétique constitutionnel ou acquis et des cellules soumises à un stress environnemental.

15. Utilisation selon la revendication 14, **caractérisée en ce que** lesdites cellules présentant un défaut génétique sont des cellules cancéreuses ou des cellules infectées par un virus.

16. Utilisation d'un procédé selon l'une quelconque des revendications 1 à 12 pour identifier un métabolite intracellulaire spécifique d'un type cellulaire et/ou d'un état métabolique cellulaire et/ou de conditions environnementales cellulaires.

17. Utilisation d'un procédé selon les revendications 10, 11 ou 12 quand dépandant de la revendication 10 ou 11, pour
a) déterminer la répartition de métabolites intracellulaires ayant incorporé ledit isotope stable ; et/ou
b) déterminer qualitativement les voies métaboliques à l'origine de la formation desdits métabolites ; et/ou
c) déterminer quantitativement les flux intracellulaires générés par la catalyse enzymatique.

## Claims

1. A method for analyzing the chemical state of living cells using nuclear magnetic resonance (NMR) by comparing at least one NMR spectrum and/or at least one NMR measurement value obtained on a sample of said living cells with at least one reference NMR spectrum and/or at least one reference NMR measurement value obtained on at least one reference sample of living cells, so as to identify at least one peak of said NMR spectrum and/or at least one NMR measurement value constituting a marker specific for the metabolic state of said living cells, **characterized in that** it comprises a step of preparing said sample under conditions which make it possible to set the chemical state of said living cells, said sample being subjected to a very low temperature for a sufficient amount of time to stop the intracellular reactions between the moment at which said sample is taken and the moment at which the chemical state of the cells is measured, and also throughout the analysis, said preparation of said sample comprising the following steps:
a) directly and immediately immersing said sample in liquid nitrogen or in a buffered water/methanol mixture at very low temperature;
b) lyophilizing said sample;
c) optionally storing said sample at very low temperature;
d) at the desired time for the analysis, mixing and redissolving said lyophilized sample, at very low temperature, with a solvent having a very low melting point.

2. The method as claimed in claim 1, **characterized in that** said water/methanol mixture is buffered at pH 7.5 and contains 50% of methanol.

3. The method as claimed in claims 1 to 2, **characterized in that** said solvent is a deuterated water/deuterated methanol mixture buffered at pH 7.5 and contains 50% of methanol.

4. The method as claimed in claims 1 to 3, **characterized in that** said very low temperature is less than 0°C.

5. The method as claimed in claim 4, **characterized in that** said very low temperature is between -10 and -80°C.

6. The method as claimed in claim 4, **characterized in that** said very low temperature is less than or equal to -80°C.

7. The method as claimed in any one of the preceding claims, **characterized in that** the temperature throughout the NMR analysis is less than 0°C.

8. The method as claimed in claim 7, **characterized in that** said temperature is between -5°C and -20°C.

9. The method as claimed in any one of the preceding claims, **characterized in that** the analysis of the chemical state of said cell is carried out by HRMAS NMR, preferably by two-dimensional HRMAS NMR.

10. The method as claimed in any one of the preceding claims, **characterized in that** said sample is taken from a cell or tissue culture medium which contains molecules enriched in stable isotopes, in which said living cells are cultured or incubated.

11. Method as claimed in claim 10, **characterized in that** said molecules comprise a source of carbon 13 and/or a source of nitrogen 15.

12. The method as claimed in any one of the preceding claims, **characterized in that** said living cells are prokaryotic or eukaryotic, animal or plant, cells.

13. The use of a method as claimed in any one of the preceding claims, for identifying living cells the physiological state of which deviates from the norm.

14. The use as claimed in claim 13, **characterized in that** said living cells belong to the group composed of cells exhibiting a constitutional or acquired genetic defect and cells subjected to an environmental stress.

15. The use as claimed in claim 14, **characterized in that** said cells exhibiting a genetic defect are cancer cells or cells infected with a virus.

16. The use of a method as claimed in any one of claims 1 to 12, for identifying an intracellular metabolite specific for a cell type and/or for a cellular metabolic state and/or for cellular environmental conditions.

17. The use of a method as claimed in claims 10, 11 or 12 when depending on claim 10 or 11, for:
a) determining the distribution of intracellular metabolites having incorporated said stable isotope; and/or
b) quantitatively determining the metabolic pathways responsible for the formation of said metabolites; and/or
c) quantitatively determining the intracellular fluxes generated by the enzymatic catalysis.

## Patentansprüche

1. Verfahren zur Analyse des chemischen Zustands lebender Zellen unter Verwendung von Kemspinresonanz (NMR) durch Vergleich mindestens eines NMR Spektrums und/oder mindestens eines NMR Messwerts, der von einer Probe der lebenden Zellen erhalten wurde, mit mindestens einem NMR Spektrum und/oder mindestens einem NMR Referenzmesswert, der von mindestens einer Probe lebender Referenzzellen erhalten wurde, um mindestens einen Gipfelpunkt des NMR Spektrums und/oder mindestens einen NMR Messwert zu erhalten, der einen spezifischen Marker des metabolischen Zustands der lebenden Zellen darstellt, **dadurch gekennzeichnet, dass** es einen Schritt der Herstellung der Probe unter Bedingungen umfasst, die es gestatten, den chemischen Zustand der lebenden Zellen zu konservieren, wobei die Probe einer sehr niedrigen Temperatur während eines Zeitraums unterworfen wird, der ausreicht, um die intrazellulären Reaktionen zwischen dem Moment der Entnahme der Probe und dem Moment der Messung des chemischen Zustands der Zellen und ebenso während der gesamten Dauer der Analyse zu stoppen, wobei die Herstellung der Probe die folgenden Schritte umfasst
a) direktes und unmittelbares Eintauchen der Probe in flüssigen Stickstoff oder ein gepuffertes Wasser/Ethanol-Gemisch bei sehr niedriger Temperatur,
b) Gefriertrocknung der Probe,
c) gegebenenfalls Lagerung der Probe bei sehr niedriger Temperatur,
d) im zur Analyse gewünschten Moment, die Mischung und die Rücküberführung in Lösung der gefriergetrockneten Probe bei sehr niedriger Temperatur mit einem Lösemittel, das einen sehr niedrigen Schmelzpunkt aufweist.

2. Verfahren nach Anspruch 1, **dadurch gekennzeichnet, dass** das Wasser/Ethanol-Gemisch bei pH 7,5 gepuffert ist und 50 % Methanol enthält.

3. Verfahren nach Anspruch 1 bis 2, **dadurch gekennzeichnet, dass** das Lösemittel ein Gemisch aus deuteriertem Wasser/deuteriertem Methanol ist, das bei pH 7,5 gepuffert ist und 50 % Methanol enthält.

4. Verfahren nach Anspruch 1 bis 3, **dadurch gekennzeichnet, dass** die sehr niedrige Temperatur unterhalb von 0 °C liegt.

5. Verfahren nach Anspruch 4, **dadurch gekennzeichnet, dass** die sehr niedrige Temperatur zwischen -10 und -80 °C liegt.

6. Verfahren nach Anspruch 4, **dadurch gekennzeichnet, dass** die sehr niedrige Temperatur unterhalb oder bei -80 °C liegt.

7. Verfahren nach einem der vorherigen Ansprüche, **dadurch gekennzeichnet, dass** die Temperatur während der Dauer der NMR Analyse unterhalb von 0 °C liegt.

8. Verfahren nach Anspruch 7, **dadurch gekennzeichnet, dass** die Temperatur zwischen -5 °C und -20 °C liegt.

9. Verfahren nach einem der vorherigen Ansprüche, **dadurch gekennzeichnet, dass** die Analyse des chemischen Zustands der Zelle durch hoch auflösende MAS-NMR, vorzugsweise durch hoch auflösende zweidimensonale MAS-NMR durchgeführt wird.

10. Verfahren nach einem der vorherigen Ansprüche, **dadurch gekennzeichnet, dass** die Probe in einem Zell- oder Gewebekulturmedium entnommen wird, das mit stabilen Isotopen angereicherte Moleküle enthält, worin die lebenden Zellen kultiviert oder inkubiert sind.

11. Verfahren nach Anspruch 10, **dadurch gekennzeichnet, dass** die Moleküle eine Kohlenstoff-13 Quelle und/oder eine Stickstoff-15 Quelle umfassen.

12. Verfahren nach einem der vorherigen Ansprüche, **dadurch gekennzeichnet, dass** es sich bei den lebenden Zellen um prokaryotische oder eukaryotische, Tier- oder Pflanzenzellen handelt.

13. Verwendung eines Verfahrens nach einem der vorherigen Ansprüche zur Identifizierung von lebenden Zellen, deren physiologischer Zustand von der Norm abweicht.

14. Verwendung nach Anspruch 13, **dadurch gekennzeichnet, dass** die lebenden Zellen zur Gruppe gehören, die aus Zellen besteht, welche einen konstitutionellen oder erworbenen genetischen Defekt zeigen sowie Zellen, welche einem Umweltstress unterworfen sind.

15. Verwendung nach Anspruch 14, **dadurch gekennzeichnet, dass** es sich bei den Zellen, welche einen genetischen Defekt zeigen, um Krebszellen oder Zellen handelt, die von einem Virus infiziert wurden.

16. Verwendung eines Verfahrens nach einem der Ansprüche 1 bis 12 zur Identifizierung eines intrazellulären Stoffwechselprodukts, das für einen Zelltyp und/oder einen zellulären Stoffwechselzustand und/oder zelluläre Umgebungsbedingungen spezifisch ist.

17. Verwendung eines Verfahrens nach einem der Ansprüche 10, 11 oder 12, insoweit als dieser von den Ansprüchen 10 oder 11 abhängig ist, zum
a) Bestimmen der Verteilung intrazellulärer Stoffwechselprodukte, die das stabile Isotop beinhalten, und/oder
b) qualitativen Bestimmen der Stoffwechselwege zum Ursprung der Bildung der Stoffwechselprodukte, und/oder
c) quantitativen Bestimmen der intrazellulären Flüsse, die durch enzymatische Katalyse erzeugt werden.
